Europäisches Patentamt

European Patent Office

Office européen des brevets

(11) Publication number: **0 078 480**
A2

## (12) EUROPEAN PATENT APPLICATION

(21) Application number: **82109845.6**

(22) Date of filing: **25.10.82**

(51) Int. Cl.³: **H 01 L 21/60, H 01 L 23/48**

(30) Priority: **28.10.81 JP 171411/81**

(43) Date of publication of application: **11.05.83 Bulletin 83/19**

(84) Designated Contracting States: **DE FR**

(71) Applicant: **Hitachi, Ltd., 5-1, Marunouchi 1-chome, Chiyoda-ku Tokyo 100 (JP)**

(72) Inventor: **Ohshima, Muneo Hitachi Hachimanyama, Apartment No. 113, 1545 Yoshida-cho Totsuka-ku, Yokohama-shi Kanagawa-ken (JP)**
Inventor: **Kenmotsu, Akihiro, 866-15, Kameino, Fujisawa-shi Kanagawa-ken (JP)**

(74) Representative: **Patentanwälte Beetz sen. - Beetz jun. Timpe - Siegfried - Schmitt-Fumian, Steinsdorfstrasse 10, D-8000 München 22 (DE)**

(54) Method for fusing and connecting solder of IC chip.

(57) Disclosed is a method for solder-fusing and connecting an IC chip which comprises locating solder bumps for electric connection, disposed on an IC chip, and a metallic layer for controlling the shape of connecting portions, disposed on the IC chip having said solder bumps and having a melting point higher than the melting point of the solder bumps, to terminals for electric connection and to terminals for controlling the shape of the connecting portions, disposed on a substrate, respectively; heat-fusing the solder bumps to form the connecting portions having the swelling shape at the center; and heat-fusing the metallic layer at a higher temperature to form bumps for controlling the shape of connecting portions, having the swelling shape at the center, and changing the connecting portions having the swelling shape at the center to connecting portions having the contracted shape at the center.

S P E C I F I C A T I O N

TITLE OF THE INVENTION:

METHOD FOR FUSING AND CONNECTING SOLDER OF IC CHIP

BACKGROUND OF THE INVENTION

Field of the Invention

This invention relates to a method for fusing and connecting solder bumps disposed on an integrated circuit element ( hereinafter referred to as the "IC chip") to terminals disposed on a substrate.

Description of the Prior Art

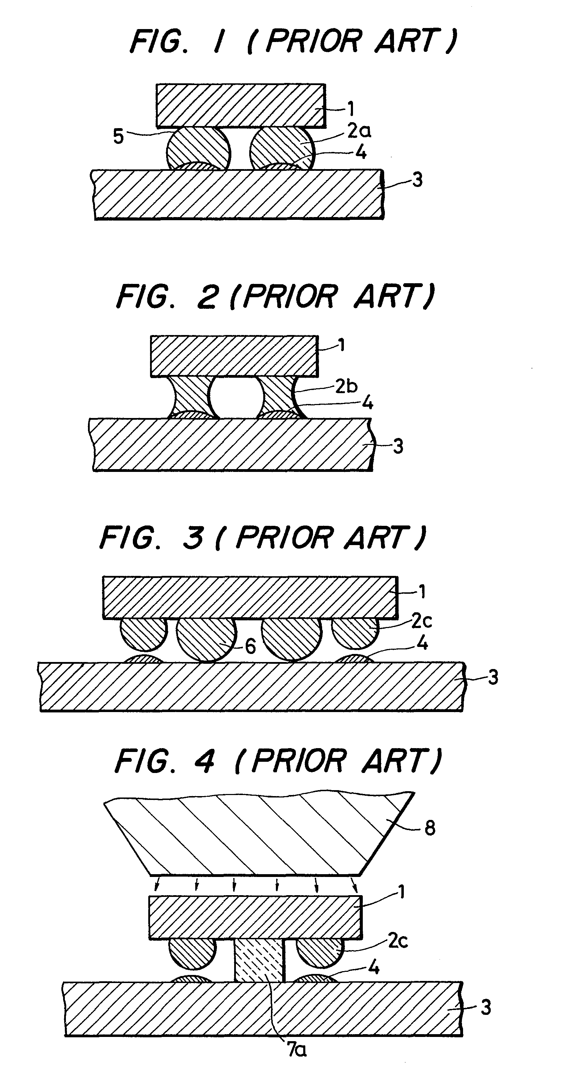

In packaging ICs, LSIs and the like in high density, it has been a customary practice to first align solder bumps on an IC chip 1, for example, with terminals 4 on a substrate 3 and then to fuse the solder bumps to form connecting portions 2a for electric connection as depicted in Figure 1.  The connecting portion 2a thus formed swells at its center.  When thermal strain is applied to this connecting portion, stress concentrates upon the most contracted bond portion 5 of this solder connecting portion 2a so that the connecting portion 2 undergoes fatigue rupture within a short period.

It has been reported that the thermal fatigue properties of this solder connecting portion 2a can be drastically improved by changing its shape (Verner D. Cooms, "Fatigue Properties of Pure Metal Solders", Inter Microelectronic Symp., p.p. 67 - 72, 1976).  In other
words, it has been reported that most preferably, the
connecting portion is contracted at its center, as
typified by the connecting portion 2b shown in Figure 2.
To form such a connecting portion 2b, a method has
been known which forms shape controlling bumps 6 having
a large solder volume in addition to the solder bumps
2c for electric connection on the IC chip as shown in
Figure 3 so as to keep the solder bumps 2c spaced
apart from the terminals 4, then heats and fuses the bumps
to form the solder connecting portions having the shape
2b of Figure 2 (Japanese Patent Publication No. 28735/1968).

However, the method described above is not free from
the following problem.  When the volume of the shape controlling bumps 6 is greater than a certain volume, locating becomes difficult in forming the solder connecting
portions 2b, which are contracted at the center as shown
in Figure 2, by fusing the solder bumps 2c for electric
connection.  In that case, solder connection can not be
made satisfactorily.  To insure good solder connection,
the solder bumps 2c for electric connection must be fused
and connected to the terminals 4 while the IC ship 1 is
being pressed and heated and heat-treatment is then
effected once again while the IC chip is not pressed.
However, this method results in the increase in the number

- 3 -

0078480

of work steps and load control is difficult.

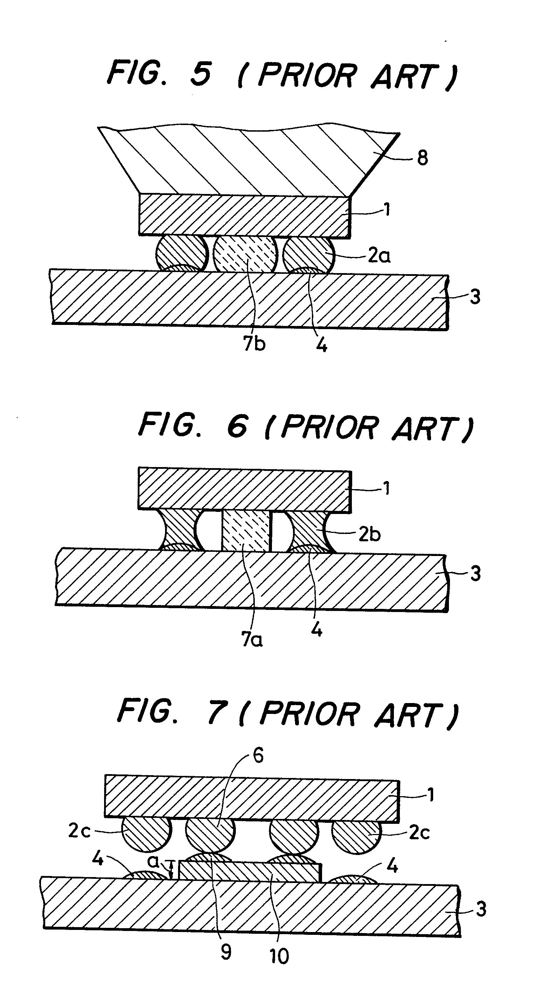

Japanese Patent Laid-Open No. 88077/1974 discloses another method, which is illustrated in Figures 4 through 6. According to this method, a support 7a consisting of a high molecular weight polymer, which can be removed, is disposed on a substrate 3 as shown in Figure 4 and is softened and changed into a support 7b when heating is subsequently made by heating means 8 in the packaging step of the IC chip 1. At the same time, limited force is applied by the heating means 8 and the corresponding solder bumps 2c for electric connection are fused and connected to the terminals 4, forming the solder connecting portions $2_a$ shown in Figure 5. During the subsequent cooling step, the support 7b attempts to return to its original thickness and this force changes the support 7b to a support 7a. At the same time, the connecting portions 2a are stretched by this force, forming the connecting portions 2b having the contracted shape at the center, as shown in Figure 6.

However, since the coefficient of thermal expansion of the support 7a is different from that of the solder connecting portion 2b contracted at the center, the solder connecting portions 2b are repeatedly subjected to heating and cooling and thermal fatigue is accelerated.

Accordingly, the support 7a must be removed. However, if a cap is applied for sealing after this support 7a is removed, the connecting portion 2b having the contracted portion at the center is simultaneously fused when the chip is again heated as a whole so that the connecting portion 2b returns to the solder connecting portion 2a having the original shape.

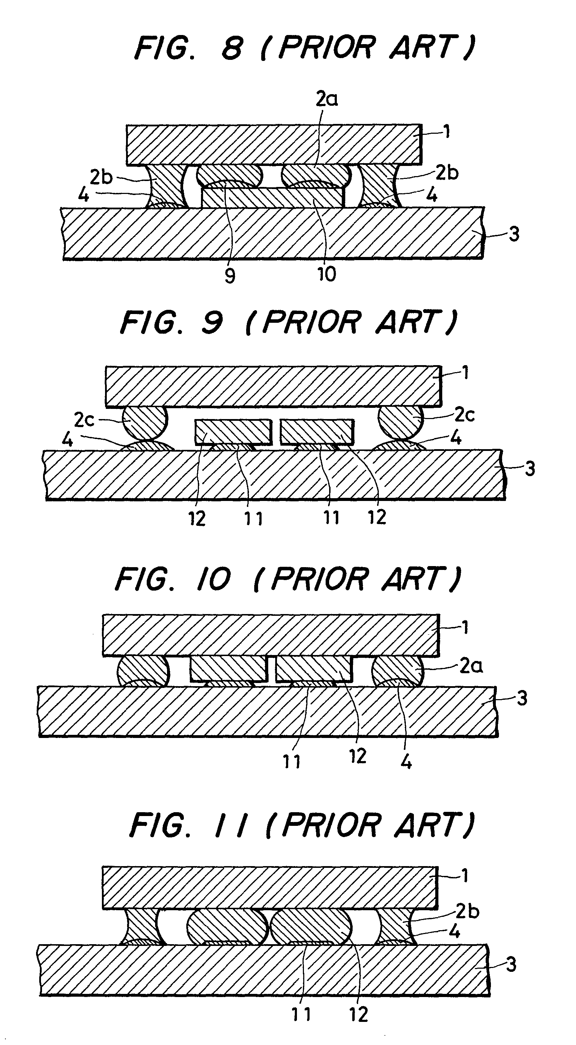

In accordance with a third method, a protuberance 10 having a step a is formed on the substrate 3 by printing an insulating material as shown in Figure 7 and the solder bumps 2c for electric connection and the terminals 4 are heat-treated to obtain the connecting portions 2b having the contracted shape at the center, as shown in Figure 8. However, if the terminals 4 are formed after the protuberance 4 is formed, the shape of the terminal 4 close to the boundary of the protuberance 10 becomes inaccurate due to the step a. If the terminal 4 is first formed, the protuberance 10 is then formed and thereafter a terminal 9 is further formed on the upper surface of the protuberance 10, the accuracy of the position of the terminal 9 relative to the terminal 4 drops.

A fourth method is proposed in Japanese Utility Model Application No. 155903/1979, which is diagrammatically shown in Figures 9 through 11. To control the shape of the connecting portion, this method forms a plurality of metallizing portions 11 on the surface of the substrate 3 and alloy sheets 12 for controlling the shape of connecting portion, which alloy has a melting point higher than that of the solder bump 2c for electric connection, are placed on the metallizing portions 11.  The IC chip 1 is then located in the face-down arrangement and desired connection is effected by heat-fusing.  Figure 9 shows the state in which the IC chip 1 and the substrate 3 are located to each other. Figure 10 shows the state in which the solder bumps 2c for electric connection having a lower melting point are first fused into the solder connecting portions 2b. When the heating is further continued from this state, the controlling alloy 12 having a higher melting point is also fused and push   up the IC chip by its surface tension as shown in Figure 11, providing the solder connecting portions 2b having the contracted shape at the center.

However, this fourth method involves the drawback that the alloy sheets 12 for controlling the shape of the connecting portions must be disposed and the number of steps increases as much.  Depending upon  the accuracy of disposition of the alloy sheets 12, the adjacent sheets would be brought into contact with each other at the time of fusing and would cause bridge.  Hence,
the solder connecting portions 2b having the contracted
shape at the center can not be obtained.

SUMMARY OF THE INVENTION

It is therefore an object of the present invention
to provide a method of solder-connecting an IC chip
which eliminates all the problems with the prior art.
More particularly, the connecting method of the present
invention can easily form the terminals and can easily
locate the terminals to the solder bumps, and eliminates
the necessity of pressing when the solder is fused for
connection and the necessity of locating the adjacent
solder connecting portions to one another.  Furthermore,
the connecting method of the present invention eliminates
the necessity of arranging the alloy sheets having a
high melting point on the terminals so as to control
the shape of the connecting portions, can prevent the
deformation of the solder connecting portions when heating
is effected to seal the IC chip by the cap after the IC
chip is connected to the substrate by the solder bumps
and can connect under the excellent condition the solder
bumps of the IC chip to the terminals on the substrate by
fusing the solder bumps.

The connecting method in accordance with the present invention is characterized in that a controlling alloy sheet having a high melting point is formed inside the chip by vacuum evaporation using a metal mask either in the wafer state before chip dicing or in the chip state after dicing during the fabrication process of the IC chip.

A solder consisting of 37 to 95 wt% of Pb and 63 to 5 wt% of Sn is used for the solder bumps for electric connection while a composition consisting of at least 97 wt% of Pb and up to 3 wt% of Sn is used for the metallic layer for controlling the shape of the connecting portions.

BRIEF DESCRIPTION OF THE DRAWINGS

Figure 1 is a sectional view showing the solder connecting portions obtained in accordance with the conventional solder fusing connecting method;

Figure 2 is a sectional view showing the ideal shape of the solder connecting portions;

Figure 3 is a sectional view useful for explaining the first of the conventional methods to obtain the ideal solder connecting portions;

Figures 4, 5 and 6 are sectional views useful for explaining the second of the conventional methods;

Figures 7 and 8 are sectional views useful for explaining the third of the conventional methods;

Figures 9, 10 and 11 are sectional views useful for explaining the fourth of the conventional methods; and

Figures 12, 13 and 14 are a sectional view, a schematic view and a sectional view that are useful explaining one embodiment of the method of the present invention.

DESCRIPTION OF THE PREFERRED EMBODIMENTS

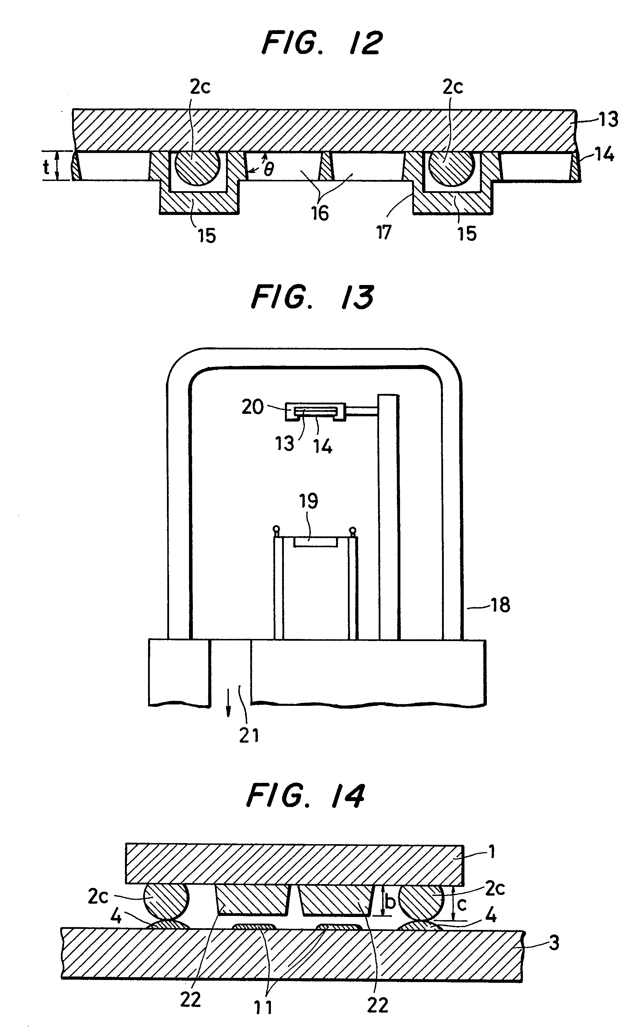

Hereinafter, one embodiment of the present invention will be described with reference to Figures 12 through 14. Figure 12 is a partial sectional view showing the state in which the solder bumps 12 for electric connection are located to a finished Si wafer 13 (before it is divided into the IC chips 1) via a metal mask 14. The metal mask 14 has recesses 15 at the positions corresponding to the solder bumps 2c lest the mask 14 comes into contact with the solder bumps 2c for electric connection. The mask also has an aperture 16 for forming an alloy layer on the wafer 13. The aperture has an angle θ so that the metal mask 14 can be easily separated from the wafer 13 after vacuum evaporation. It is further effective to dispose a recess 17 at the aperture while securing a necessary thickness (t) so that vacuum evaporation to the aperture can be carried out satisfactorily.

Figure 13 shows the relation of position between

0078480

the Si wafer 13, the metal mask 14 and a vacuum evaporation source 19 inside a vacuum evaporator 18. Reference numeral 20 represents a jig and 21 does an exhaust port.

Figure 14 shows the state in which the wafer is separated from the metal mask after completion of vacuum evaporation and dicing is applied to the IC chip. The chip is shown located to the wiring substrate. The solder connecting portion 2c consists of a solder of Pb/Sn = 95/5 (wt%) and the alloy layer 22 consists of a solder of Pb/Sn = 97/3 (wt%). The melting point of the latter is by about 5°C higher than the melting point of the former. The thickness (b) of the alloy layer 22 is up to 90% of the height (c) of the bumps 2 for electric connection. Under this state, the chip as a whole is heated inside a belt furnace or a batch furnace whereby the bumps 2c for electric connection are first fused and connection to the electrode terminals 4 of the substrate is completed. The alloy layer 22 is then fused and is bonded to the metallizing layer 11 whereupon its surface tension pushes up the IC chip 1, providing the good connecting condition such as shown in Figure 11. If the heating speed is too great, the alloy layer 22 would be fused before bonding of the solder bumps 2c for electric connection to the terminals

0078480

4 is sufficiently completed, so that the IC chip 1 is pushed up and defective connection occurs. The necessary time for completing this connection is from about 2 to about 3 seconds. Since the difference of melting point between the solder bumps 2c for electric connection and the alloy layer 22 is about 5°C, connection can be completely established if the heating speed is up to 2.5 to 5/3 °C/sec.

As described in the foregoing, a good connection shape can be obtained in accordance with the present invention and high reliability as high as 3 to 5 times in terms of thermal fatigue life can be accomplished in comparison with the prior art.

- 1 -

0078480

What is claimed is:

1.  A method for solder-fusing and connecting an IC chip comprising:  locating solder bumps for electric connection, disposed on an IC chip and a metallic layer for controlling the shape of connecting portions, disposed on said IC chip having said solder bumps and having a melting point higher than the melting point of said solder bumps, to terminals for electric connection and to terminals for controlling the shape of said connection portions, disposed on a substrate, respectively; heat-fusing said solder bumps to form said connecting portions having the swelling shape at the center; heat-fusing said metallic layer at a higher temperature to form bumps for controlling the shape of connecting portions, having the swelling shape at the center, and changing said connecting portions having the swelling shape at the center to connecting portions having the contracted shape at the center.

2.  The method for solder-fusing and connecting an IC chip as defined in cliam 1 wherein said metallic layer for controlling the shape of connecting portions, having a melting point higher than the melting point of said solder bumps for electric connection, consists of an alloy having a melting point by about 5°C higher than the melting point of said solder bumps for electric connection.

- 2 -                                    0078480

3.    The method for solder-fusing and connecting an IC chip as defined in claim 1 wherein said solder bump for electric connection consists of 37 to 95 wt% of Pb and 63 to 5 wt% of Sn and said metallic layer for controlling the shape of connecting portions, having a melting point higher than the melting point of said solder bump, consists of at least 97 wt% of Pb and up to 3 wt% of Sn.

0078480

## FIG. 1 ( PRIOR ART )

## FIG. 2 (PRIOR ART)

## FIG. 3 ( PRIOR ART )

## FIG. 4 ( PRIOR ART )

## FIG. 5 (PRIOR ART)

8
1
2a
7b
4
3

## FIG. 6 (PRIOR ART)

1
2b
7a
4
3

## FIG. 7 (PRIOR ART)

6
1
2c
2c
4
4
a
9
10
3

### FIG. 8 (PRIOR ART)

### FIG. 9 (PRIOR ART)

### FIG. 10 (PRIOR ART)

### FIG. 11 (PRIOR ART)

0078480

## FIG. 12

## FIG. 13

## FIG. 14